# EUROPEAN PATENT APPLICATION

(11) **EP 0 757 446 A2**
(43) Date of publication of application: **05.02.1997**
(21) Application number: 96303925.0
(22) Date of filing: 31.05.1996
(51) Int. Cl.: H03M 1/12, H03M 1/66

(54) **Analogue to digital and digital to analogue converters**

(30) Priority: 04.08.1995 GB 9516084
(71) Applicant: NOKIA MOBILE PHONES LTD., 24101 Salo (FI)
(72) Inventor: Byrne, John Daniel, Shepperton, Middlesex TW17 8HR (GB)
(74) Representative: Potter, Julian Mark

(57) **Abstract**

A radio telephone operative in a cellular system or a cordless system has a receiver (Figure 1), including an analogue to digital converter (9) and a transmitter (Figure 2) including a digital to analogue converter (18) The receiver has a Delta-Sigma modulator (13) and a decimation filter (14). To make the receiver operative in either the cellular or the cordless system, the bit conversion rate of the Delta-Sigma modulator (13) is programmably variable, as is the decimation rate of the decimation filter (14). Similarly, the digital to analogue converter has an interpolator (29) and a Delta-Sigma demodulator (30) which are programmably variable to suit either the cellular or cordless system.

## Description

This invention relates to analogue to digital and digital to analogue converters, particularly for use in multi-mode radio telephones.

Over the last ten years there has been a rapid growth in the use and availability of radio telephone systems. As part of this growth there has been a proliferation of different types of radio telephone system, offering the user a variety of services, geographical coverage and cost. Many of these different radio telephone systems cover the same, or a part of the same, geographical area as each other.

Typically, different radio systems operate on different radio frequencies, utilise different modulation techniques, signalling techniques and intra-system protocols etc. to each other. Thus, a radio telephone designed for one system is generally unable to be used on another system. Thus if a user wishes to have access to more than one system it is necessary to have either more than one radio telephone or a radio telephone capable of operating in more than one system. Having more than one radio telephone is inconvenient for the user. Known radio telephones capable of operating in more than one system typically consist of little more than two separate telephones combined in a single housing. The preference for operating in a particular system is user defined as disclosed in US Patent No 4 989 230.

A particularly useful and appropriate environment for multi-mode radio telephones is the recently available cellular and cordless telephone systems. In the prior art, cordless telephones are typically used in the house and office to allow the user to place and receive calls at any point throughout the house via an RF link with a home base station located within the house or office.

Such cordless telephones are connected via the home base station to the user's telephone landline which is in turn connected to the Public Switched Telephone Network (PSTN). Further, there are known second generation cordless telephone systems such as CT-2 or DECT which are digital systems. Such CT-2 or DECT systems extend beyond conventional domestic operation of cordless telephones by allowing the user to establish an RF link between a CT-2 or DECT radio telephone and a base station in a more publicly accessible location, eg outside the user's home, a railway station, shopping mall or airport. Such base stations are known as telepoint base stations and are linked to the PSTN in much the same way as a home base station. Some cordless (and in particular DECT) radio telephones, are now able to receive calls via telepoint base stations whereas hitherto they were only able to place them. A description of such a system can be found in PCT International Patent Application WO 92/03006. Thus, placing and receiving calls whilst geographically roaming is possible in cordless telephone systems.

However, cordless telephone systems are generally low power systems and each base station provides telecommunications within only approximately a 150 metre radius of the base station, dependent upon the terrain and any man-made objects which could interfere with signalling between a cordless telephone handset and the base station. Such systems are generally only used in areas of high user density and thus tend to be limited to urban areas. This clearly restricts the geographical mobility of a CT-2, DECT or the like cordless telephone user.

In the prior art there are known so-called cellular radio telephone systems having base stations which cover a wide geographical area (cell), eg 35km diameter. However, in urban areas where the user density is high the cells are much smaller and operate at lower powers to facilitate frequency re-use thereby increasing the communication channel density.

Cellular systems (such as GSM) have advantages over cordless systems since they allow a user to place and receive calls over a large area. Additionally they are suitable for use in moving vehicles. This is because cellular telephone systems have sophisticated handover procedures to facilitate switching between cells as a user's vehicle crosses from one cell to another. This ensures continuity of service and is particularly important during a call. However, the cost of a cellular telephone call is significantly greater than the cost of a cordless telephone call, since cordless telephone calls are made by way of the user's land line PSTN link and cost the same as landline calls, whilst cellular telephone calls are made by way of expensive cellular base stations and cellular switching equipment and cost much more than land line telephone calls.

In order for a user to be able to utilise both cellular and cordless telephone systems via a single radio telephone handset a so-called cellular cordless telephone (CCT) has been proposed in US Patent US 4 989 230.

A to D (analogue to digital) and D to A (digital to analogue) converters are commonly used for interfacing radio frequency circuits to digital circuits in radio telephones. Usually these converters are designed to convert with a fixed accuracy (number of bits and at a fixed rate of conversion). A multi-mode radio telephone may however require different conversion rates and different accuracies.

The object of the invention is to provide a converter operative at a conversion rate which can be varied to enable a single converter to be used in either (or any) mode or system in which the radio telephone is operating.

According to one aspect the invention provides an analogue to digital converter comprising a modulator operative to convert an analogue input signal into a digital output signal at a bit conversion rate, and a decimation filter for digitally filtering the digital output signal, wherein the modulator is controllable to vary the bit conversion rate and the filter is controllable to vary the decimation rate.

Preferably, the modulator is an oversampling quantizer, conveniently a Delta-Sigma modulator, conveniently of second order although other orders are possible. The principle of a Delta-Sigma converter is initial conversion at a much higher rate than the finally required conversion rate. The high rate conversion is normally applied at a low accuracy (number of bits), the output of this is then digitally filtered by the decimation filter, whose purpose is to convert from high frequency/low accuracy conversions to lower frequency/high accuracy conversions.

The invention also applies to digital to analogue converters where the programmable process of decimation is replaced by a programmable process of interpolation.

Hence, according to another aspect of the invention there is provided a digital to analogue converter comprising a filter operative to sample values of a digital input signal at a digital conversion rate in order to raise the word rate to a high frequency signal, and a demodulator for converting the high frequency signal to an analogue output, wherein the filter is controllable to vary the digital conversion rate and the demodulator is controllable to accept signals at differing high frequencies.

The demodulator is preferably a Delta-Sigma demodulator, conveniently of second order although other orders may be used.

A receiver incorporating an analogue to digital converter according to the invention, and a transmitter incorporating a digital to analogue converter according to the invention, will now be described by way of example with reference to the accompanying drawings, in which:
Figure 1 is a block circuit diagram of the receiver,
Figure 2 illustrates the components of the analogue to digital converter,
Figure 3 is a block circuit diagram of the transmitter, and
Figure 4 illustrates the components of the digital to analogue converter.

In general, digital cordless systems have higher over-the-air bit rates than cellular systems. For example the DECT system has 1152 bits/second and the GSM system has 271 bits/second. Due to their greater spacial range, the received signals in cellular systems have larger dynamic ranges than cordless systems. Hence, a radio telephone operative in either a cellular mode or in a cordless mode must be capable of handling different conversion accuracies dependent on the radio bit rate of the radio system selected.

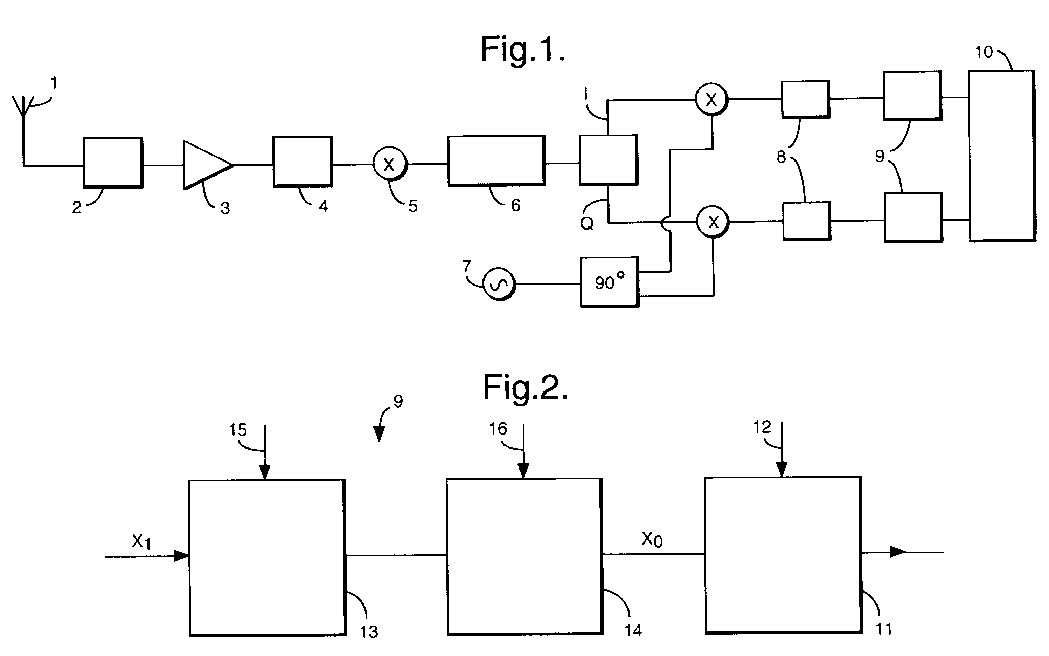

Referring to Figure 1, the receiver illustrated is part of a dual mode radio telephone operative either in a cellular mode (like GSM) or in a cordless mode (like DECT).

The receiver has an antenna 1, a filter 2, a low noise amplifier 3, a further filter 4, a local oscillator 5 and a filter 6 the output of which is split into the I and Q signal components to which are applied quadrature signals derived from a local oscillator 7. After low pass filtering at 8, the respective I and Q signals are fed to respective analogue to digital converters 9, each in accordance with the invention. The resulting digital signals are demodulated in a digital demodulator 10. The two analogue to digital converters 9 are similar and hence only one of them will be described in detail with reference to Figure 2.

The input signal Xi to the converter 9 is an analogue signal carrying the information in a pulse code modulation. The signal is subjected to oversampling digital conversion at a much higher rate than the finally required conversion rate. The high rate conversion is carried out at a low accuracy (number of bits) in a Delta-Sigma modulator 13 the output of which is then digitally filtered by low pass filters in a decimation filter 14, the purpose of which is to convert from high frequency/low accuracy conversion to lower frequency/higher accuracy conversion. Thus, the filter 14 converts the output of the modulator 13 from short digital words at high rate into an output Xₒ with long words at a lower rate.

In accordance with the invention the master clock frequency 15 used to generate the high frequency conversion rate in the modulator 13 is adjustable to ensure that the conversion rate can be related to the symbol rate. The clock is programmable so that the conversion rate suits the radio bit rate of the cellular system or the cordless system, depending on the system in which the radio telephone is operating.

Further, the decimation rate 16 of the decimation filter 14 is controllable in order to alter the balance of the conversion rate and the conversion accuracy. The greater the amount of decimation filtering applied, the lower the conversion rate and the greater the conversion accuracy. This fits well with the characteristics of many radio communication systems where higher symbol rate systems in general require less accurate conversion. For example, GSM (271 kbit/s) has a lower bit rate than DECT (1152 kbit/s) and hence a lower conversion rate.

Decimation filters are typically implemented using simple accumulate and dump filters. The order of the decimation is controlled by the number of stages of accumulate and dump employed. Therefore when selecting between high and low rate modes the number of accumulate and dump stages can be varied.

Following decimation, a finite impulse response digital filter 11 is used to remove those frequencies outside the required band and not removed by the decimation filter 14. The filter 11 should also be re-programmed when changing mode, as indicated at 12.

By keeping approximately the same oversampling rates for both modes the described arrangement has the advantage of using the same modulator.

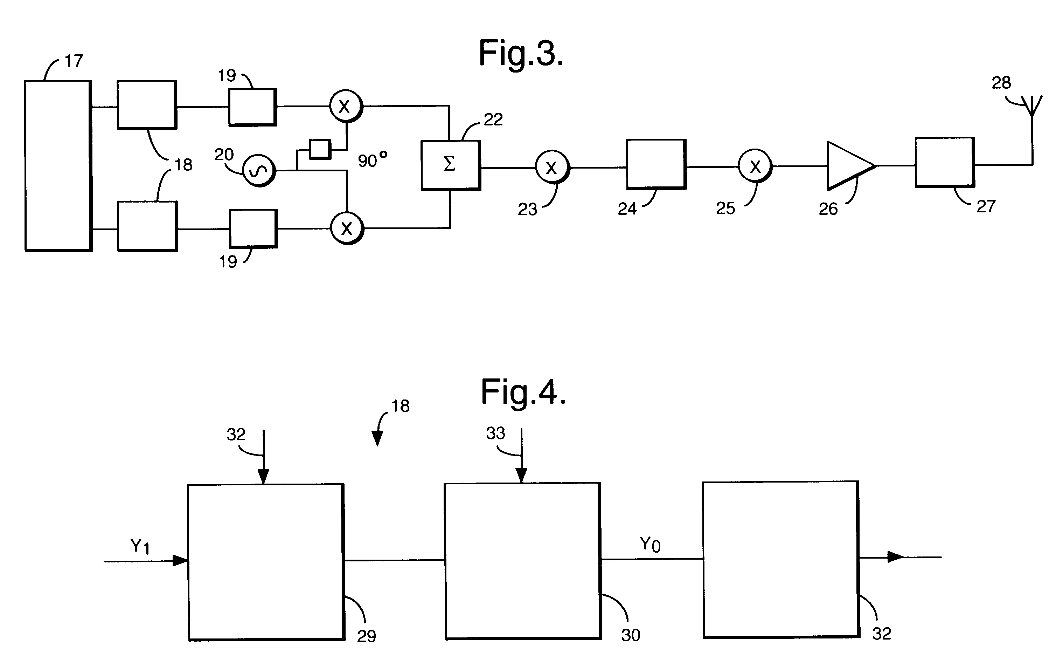

Referring to Figure 3, the transmitter illustrated is also part of the dual mode radio telephone operative in either GSM or DECT.

From a digital modulator 17, the I and Q signals are fed to respective digital to analogue converters 18 each in accordance with the invention. Thereafter, the signals pass through low pass filters 19, have the quadrature signals applied thereto from an oscillator 20 and are combined in a summer 22 to form a composite signal which is converted to a first intermediate frequency by a local oscillator 23, passed through a low pass filter 24, converted to radio frequency by a local oscillator 25, passed through a power amplifier 26 and a filter 27 before being transmitted by an antenna 28.

The two digital to analogue converters 18 are similar and hence only one of them will be described with reference to Figure 4.

The converter 18 comprises an interpolator 29 followed by a Delta-Sigma demodulator 30. The input Yᵢ to the interpolator 29 is modulation data in the form of is a digital word stream. The interpolator 29 samples values of the input signal Yᵢ in order to raise the word rate to a high frequency. This increase in word rate is controllable (as indicated at 32) by programming so that the increase in word rate is suited to the cordless system or the cellular system, dependent on the system in which the radio telephone is operating at any particular time. The result is that the interpolator 29 is programmable to alter the balance of conversion rate and conversion accuracy. The Delta-Sigma demodulator 30 is also adjustable as indicated at 33, in that its high frequency clock is programmable to ensure that the conversion rate can be related to the symbol rate, to suit the cellular or cordless system. The demodulator 30 truncates the digital words produced by the interpolator 29 and converts them to an analogue output Yₒ at a high rate. The output Yₒ is then fed to an analogue filter 32.

The linear interpolator 29 inserts a number of sub-samples between each received sample. Sample repeating may also be used to raise the sampling rate. A high demodulator sampling rate is desired to ease analog filtering requirements. The demodulator 30 uses reduced precision inputs to reduce complexity.

By keeping approximately the same demodulator frequency for both modes the described arrangement has the advantage that the same analog filter 32 can be used for both modes.

## Claims

1. An analogue to digital converter comprising a modulator operative to convert an analogue input signal into a digital output signal at a bit conversion rate, and a decimation filter for digitally filtering the digital output signal, wherein the modulator is controllable to vary the bit conversion rate and the filter is controllable to vary the decimation rate.

2. An analogue to digital converter according to claim 1, wherein the modulator is an oversampling quantizer.

3. An analogue to digital converter according to claim 2, wherein the modulator is a Delta-Sigma modulator.

4. An analogue to digital converter according to claim 3, wherein the Delta-Sigma modulator is a second order Delta-Sigma modulator.

5. An analogue to digital converter according to any preceding claim and included in a receiver of a multi-mode radio telephone.

6. A digital to analogue converter comprising a filter operative to sample values of a digital input signal at a digital conversion rate in order to raise the word rate to a high frequency signal, and a demodulator for converting the high frequency signal to an analogue output, wherein the filter is controllable to vary the digital conversion rate and the demodulator is controllable to accept signals at differing high frequencies.

7. A digital to analogue converter according to claim 6, wherein the demodulator is a Delta-Sigma demodulator.

8. A digital to analogue converter according to claim 7, wherein the Delta-Sigma demodulator is a second order Delta-Sigma demodulator.

9. A digital to analogue converter according to any of claims 6 to 8 and included in a transmitter of a multi-mode radio telephone.

10. A multi-mode radio telephone according to claim 5 or 9, wherein the telephone is operative in either a cellular mode or a cordless mode.
